# EUROPEAN PATENT APPLICATION

(11) **EP 2 413 675 A1**
(43) Date of publication of application: **01.02.2012**
(21) Application number: 11168521.0
(22) Date of filing: 01.06.2011
(51) Int. Cl.: H05K 3/30, H05K 3/32

(54) **Connector module and electronic device having the same**

(30) Priority: 28.07.2010 KR 20100072712
(71) Applicant: Samsung Electronics Co., Ltd., Suwon-si, Gyeonggi-do 442-742 (KR)
(72) Inventor: Heo, Jae Cheol, Suwon-si (KR)
(74) Representative: Waddington, Richard

(57) **Abstract**

A connector module (30) includes a first housing (31), a plurality of first connection ports (41) provided at a first surface of the first housing, first connection pins (51) connected to the first connection ports and to a circuit board (20), a second housing (32), second connection ports (42) provided at a first surface of the second housing, and second connection pins (52) connected to the second connection ports and to the circuit board. Both the first connection pins (51) and the second connection pins (52) are provided on a second surface (32a) of one of the first housing and the second housing, wherein the second surface faces the circuit board.

## Description

### BACKGROUND

### 1. Field

Apparatuses consistent with exemplary embodiments relate to a connector module, which is used to be connected with external devices, and an electronic device having the connector module.

### 2. Description of the Related Art

Electronic devices include audio and video reproducing devices, such as televisions (TVs) and audio systems. These electronic devices are connected with external devices to receive video or audio signals from the external devices. Here, the external devices include, for example, video devices, personal computers, and satellite receivers.

An electronic device includes connecters which connect with cables of the external devices. The connectors are connected to a printed circuit board (PCB) of the electronic device. A plurality of connectors are provided and occupy a certain area on the printed circuit board. The plurality of connectors include, for example, component connectors, Syndicat francais des Constructeurs d'Appareils Radio et Television (SCART) connectors, and D-subminiature (DSUB) connectors.

### SUMMARY

tone or more exemplary embodiments provide a connector module, which reduces an area occupied thereby on a printed circuit board, and an electronic device having the connector module.

According to the present invention there is provided an apparatus and method as set forth in the appended claims. Other features of the invention will be apparent from the dependent claims, and the description which follows.

In accordance with an aspect of an exemplary embodiment there is provided a connector module including a first housing, first connection ports provided at one side of the first housing, first connection pins connected to the first connection ports and a printed circuit board, a second housing, second connection ports provided at one side of the second housing, and second connection pins connected to the second connection ports and the printed circuit board, wherein both the first connection pins and the second connection pins are provided on one surface of one of the first housing and the second housing facing the printed circuit board. The first housing and the second housing may be vertically stacked, and the first connection pins and the second connection pins may be protruded from the lower surface of the second housing.

The first connection ports provided at the side of the first housing and the second connection ports provided at the side of the second housing may be arranged at a designated angle.

The first connection pins and the second connection pins may at least partially intersect.

The first connection pins may be arranged in a plurality of lines, the second connection pins may be arranged in a plurality of lines, and the plurality of lines of the first connection pins and the plurality of lines of the second connection pins may be alternately arranged.

The first connection ports and the second connection ports may be component connection ports, and the first connection pins and the second connection pins may be component connection pins.

The first connection ports and the second connection ports may be SCART connection ports, and the first connection pins and the second connection pins may be SCART connection pins. One connection port of each of the first connection ports and the second connection ports may be a component connection port and the other connection port of each of the first connection ports and the second connection ports may be a SCART connection port, and corresponding thereto, one connection pin of each of the first connection pins and the second connection pins may be a component connection pin and the other connection pin of each of the first connection pins and the second connection pins may be a SCART connection pin.

The first connection pins may be provided at one portion of the lower surface of the second housing, and the second connection pins may be provided at the other portion of the lower surface of the second housing.

One connection port of each of the first connection ports and the second connection ports may be a component connection port and the other connection port of each of the first connection ports and the second connection ports may be a DSUB connection port, and corresponding thereto, one connection pin of each of the first connection pins and the second connection pins may be a component connection pin and the other connection pin of each of the first connection pins and the second connection pins may be a DSUB connection pin.

One connection port of each of the first connection ports and the second connection ports may be a SCART connection port and the other connection port of each of the first connection ports and the second connection ports may be a DSUB connection port, and corresponding thereto, one connection pin of each of the first connection pins and the second connection pins may be a SCART connection pin and the other connection pin of each of the first connection pins and the second connection pins may be a DSUB connection pin.

The connector module may further include a third housing, third connection ports provided at one side of the third housing, and third connection pins connected to the third connection ports and the printed circuit board, and all of the first connection pins, the second connection pins, and the third connection pins may be provided on one surface of one of the first housing, the second housing, and the third housing facing the printed circuit board.

The first connection ports of the first housing, the second connection ports of the second housing, and the third connection ports of the third housing may be arranged at designated angles.

In accordance with an aspect of another exemplary embodiment, there is provided a connector module including a housing, first connection ports provided at one side of the housing, first connection pins connected to the first connection ports and a printed circuit board, second connection ports provided at another side of the housing, and second connection pins connected to the second connection ports and the printed circuit board, wherein both the first connection pins and the second connection pins are provided on one surface of the housing facing the printed circuit board.

The first connection ports and the second connection ports may be arranged at a designated angle.

In accordance with an aspect of another exemplary embodiment, there is provided an electronic device including a main body, a printed circuit board provided on the main body; and a connector module connected to the printed circuit board, wherein a connector module includes a first housing, first connection ports provided on the first housing, first connection pins connected to the first connection ports and the printed circuit board, a second housing, second connection ports provided on the second housing, and second connection pins connected to the second connection ports and the printed circuit board, wherein both the first connection pins and the second connection pins are provided on one surface of one of the first housing and the second housing facing the printed circuit board.

In accordance with an aspect of another exemplary embodiment, there is provided an electronic device including: a circuit board; and a connector module connected to the printed circuit board, wherein a connector module including: a housing; a plurality of first connection ports provided on a first surface of the housing; a plurality of first connection pins interconnecting the plurality of first connection ports and the circuit board and extending through a second surface of the housing; a plurality of second connection ports provided on a third surface of the housing; and a plurality of second connection pins interconnecting the plurality of second connection ports and the circuit board, and extending through the second surface of the housing.

The plurality of first connection pins may be arranged in a plurality of lines along the second surface of the housing and the plurality of second connection pins may be arranged in a plurality of lines along the surface of the housing, wherein the lines of the first connection pins may be alternately arranged with the lines of ht second connection pins.

The first surface of the housing and the third surface of the housing may be angled relative to one another.

A plurality of third connection ports may be provided on a third surface of the housing; and a plurality of third connection pins may intersect the plurality of third connection ports and the circuit board and extend through the second surface of the housing.

The plurality of first connection pins may be arranged in a plurality of lines along the second surface of the housing, the plurality of second connection pins may be arranged in a plurality of lines along the surface of the housing, and the plurality of third connection pins may be arranged in a plurality of lines along the second surface of the housing, wherein the lines of the first connection pins, the lines of the second connection pins, and the lines of the third connection pins may be alternately arranged.

The third surface of the housing may be angled relative to the first surface of the housing and the second surface of the housing.

### BRIEF DESCRIPTION OF THE DRAWINGS

These and/or other aspects will become apparent and more readily appreciated from the following description of the exemplary embodiments, taken in conjunction with the accompanying drawings of which:
FIG. 1 is a perspective view illustrating an electronic device in accordance with one exemplary embodiment;
FIG. 2 is a partially cut away side view of the electronic device of FIG. 1;
FIG. 3 is a perspective view illustrating a connector module in accordance with one exemplary embodiment;
FIG. 4 is a side cross-sectional view of the connector module of FIG. 3;
FIG. 5 is bottom view of the connector module of FIG. 3;
FIG. 6A is a perspective view illustrating a connector module in accordance with another exemplary embodiment;
FIG. 6B is a bottom view of the connector module of FIG. 6A;
FIG. 7A is a perspective view illustrating a connector module in accordance with another exemplary embodiment;
FIG. 7B is a bottom view of the connector module of FIG. 7A;
FIG. 8A is a perspective view illustrating a connector module in accordance with another exemplary embodiment;
FIG. 8B is a bottom view of the connector module of FIG. 8A;
FIG. 9A is a perspective view illustrating a connector module in accordance with another exemplary embodiment;
FIG. 9B is a bottom view of the connector module of FIG. 9A;
FIG. 10 is a side cross-sectional view illustrating a connector module in accordance with another exemplary embodiment; and
FIG. 11 is a side cross-sectional view illustrating a connector module in accordance with a further exemplary embodiment.

### DETAILED DESCRIPTION

Reference will now be made in detail to the exemplary embodiments which are illustrated in the accompanying drawings, wherein like reference numerals refer to like elements throughout. Expressions such as "at least one of," when preceding a list of elements, modify the entire list and not the individual elements of the list.

Hereinafter, a connector module and an electronic device having the same in accordance with an exemplary embodiment will be described in detail with reference to the accompanying drawings.

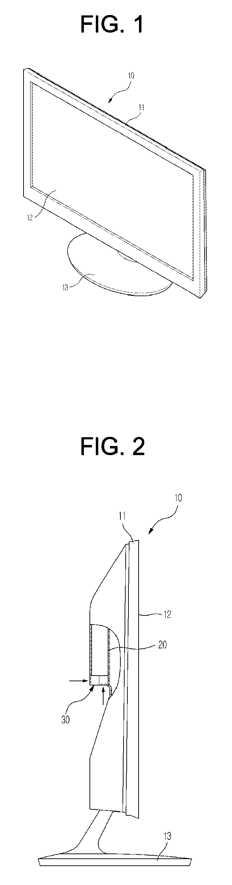

FIG. 1 is a perspective view illustrating the electronic device in accordance with this exemplary embodiment, and FIG. 2 is a partially-cut cross-sectional view of the electronic device of FIG. 1.

An electronic device 10 may include an audio and video reproducing device, such as a TV or an audio system. FIGS. 1 and 2 illustrate a TV as the electronic device 10.

The display unit 12 is provided in front of the main body 11. The display unit 12 displays various images.

Further, various circuit arrangements are installed at the rear of the main body 11. The various circuit arrangements are operated to display the various images on the display unit 12. For example, as shown in FIG. 2, a printed circuit board 20 and a connector module 30 are installed on the rear surface of the display unit 12.

A stand 13 is provided under the main body 11. The stand 13 stably supports the main body 11.

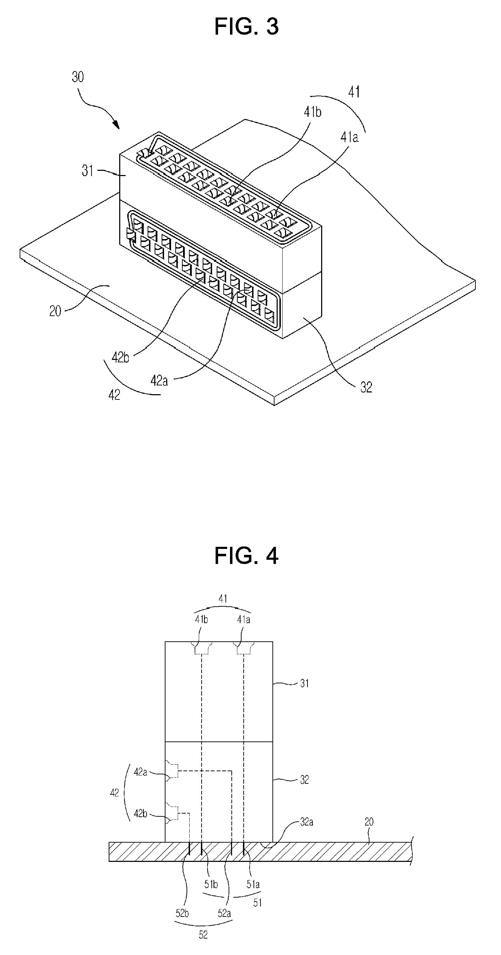

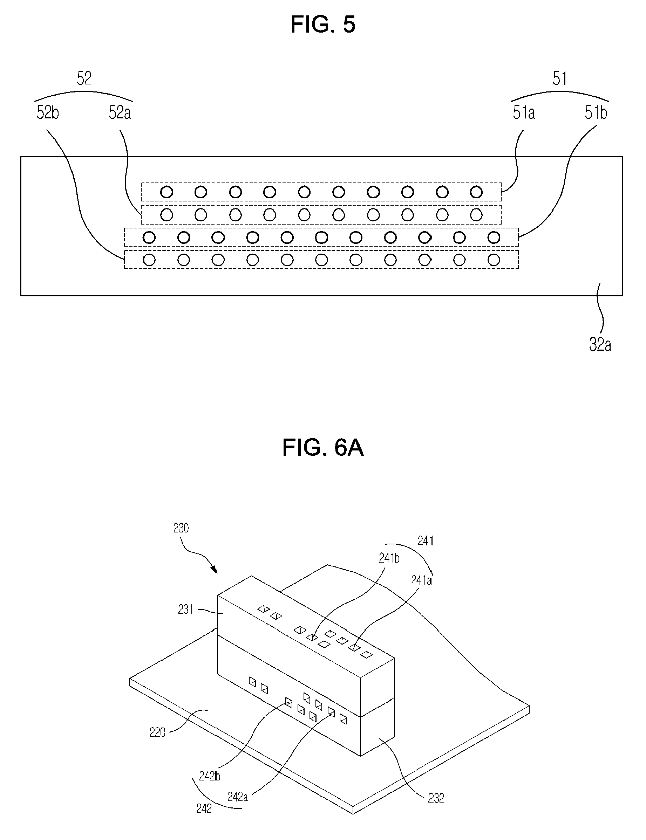

FIG. 3 is a perspective view illustrating a connector module 30 in accordance with one exemplary embodiment, FIG. 4 is a cross-sectional view of the connector module of FIG. 3, and FIG. 5 is bottom view of the connector module of FIG. 3.

As shown in FIGS. 1 to 5, the connector module 30 includes a first housing 31, first connection ports 41 provided on the first housing 31, first connection pins 51 connected to the first connection ports 41, a second housing 32, second connection ports 42 provided on the second housing 32, and second connection pins 52 connected to the second connection ports 42. The connector module 30 is mounted on the printed circuit board 20, and is connected with cables of external devices.

The first housing 31 and the second housing 32 are stacked vertically, i.e., one is disposed on top of the other. The first housing 31 and the second housing 32 are connected to each other by various connection methods. The first housing 31 and the second housing 32 stacked vertically reduce an area occupied thereby on the printed circuit board 20. That is, since the first housing 31 is not directly mounted on the printed circuit board 20, an area occupied by the first housing and the second housing 32 on the printed circuit board 20 may be reduced by as much as an area which the first housing 31 occupies.

The first housing 31 and the second housing 32 are made of plastic. Of course, materials for the first housing 31 and the second housing 32 are not limited thereto, and may be metal.

The first connection ports 41 are provided on the first housing 31. The first connection ports 41 are connected with a cable (not shown) of an external device. In FIGS. 3 to 5, the first connection ports 41 represent SCART connection ports. Here, twenty-one SCART connection ports are provided. However, the type of connection ports and the number of connection ports are not limited to those illustrated in the exemplary embodiment.

The first connection ports 41 are arranged in plural lines. For example, the first connection ports 41 includes a first line 41a including a number of connection ports 41, for example ten connection portions, and a second line 41b including a number of connection ports 41, for example 11 connection ports.

The first connection pins 51 are respectively connected to the first connection ports 41, and are then connected to the printed circuit board 20. In the exemplary embodiment of FIGS. 3-5, twenty-one first connection pins 51 are provided.

The first connection pins 51 are arranged in plural lines. For example, the first connection pins 51 includes a first line 51a including a number of connection pins 51, such as ten connection pins, and a second line 51b including a number of connection pins 51, such as eleven connection pins.

The second connection ports 42 are provided on the second housing 32. The second connection ports 42 are connected with a cable (not shown) of an external device. In FIGS. 3 to 5, the second connection ports 42 represent SCART connection ports. Here, twenty-one SCART connection ports are provided. However, the type of connection ports and the number of connection ports are not limited to those illustrated in the exemplary embodiment.

The second connection ports 42 are arranged in plural lines. For example, the second connection ports 42 includes a first line 42a including a number of connection ports 42, such as ten connection parts, and a second line 42b including a number of connection ports 42, such as eleven connection ports.

The second connection pins 52 are respectively connected to the second connection ports 42, and are then connected to the printed circuit board 20. In the exemplary embodiment, twenty-one second connection pins 52 are also provided.

The second connection pins 52 are arranged in plural lines. For example, the second connection pins 52 includes a first line 52a including a number of connection pins 52, such as ten connection pins, and a second line 52b including a number of connection pins 52, such as eleven connection pins.

Particularly, as shown in FIG. 5, both the first connection pins 51 and the second connection pins 52 are provided on a lower surface 32a of the second housing 32, the lower surface 32a facing the printed circuit board 20. The first connection pins 51 and the second connection pins 52 protrude from the lower surface 32a of the second housing 32. Here, a length of the first connection pins 51 and the second connection pins 52 that protrudes from the lower surface 32a of the second housing 32 may be less than 5mm.

The first connection pins 51 and the second connection pins 52 are arranged such that the first connection pins 51 at least partially intersect the second connection pins 52 when viewed from a direction parallel to the direction along which the plural lines are arranged, and parallel to the surfaces on which the first and second connection ports are disposed, e.g., when viewed as shown in FIG. 4. That is, the plural lines 51a and 51b of the first connection pins 51 and the plural lines 52a and 52b of the second connection pins 52 alternate with each other. For example, as best shown in FIG. 5, the first line 51a of the first connection pins 51, the first line 52a of the second connection pins 52, the second line 51b of the first connection pins 51, and the second line 52b of the second connection pins 52 are sequentially arranged in this order. The alternate arrangement of the first connection pins 51 and the second connection pins 52 reduces an area occupied by the connector module 30 on the printed circuit board 20. This arrangement occupies a smaller area on the circuit board because the connection pins 51, 52, which require a small amount of area in comparison to the connection ports 41, 42, may be disposed with small spacing therebetween. Because the connection ports 41, 42 of every other line are disposed on different surfaces the housings, the first connection ports 41 and second connection ports 42 are spaced apart a sufficient amount even though the connection pins 51, 52 are spaced apart a small amount.

The first connection ports 41 provided on the first housing 31 and the second connection ports 42 provided on the second housing 32 are arranged at a designated angle relative to one another. For example, as shown in FIG. 4, the first connection ports 41 are exposed in the upward direction, and the second connection ports 42 are exposed in the forward direction (leftward direction in the drawings). That is, the first connection ports 41 and the second connection ports 42 are separated by an angle of about 90°. In this case, interference between the cable connected with the first connection ports 41 and the cable connected with the second connection ports 42 is not generated. Here, the angle between the first connection ports 41 and the second connection ports 42 is not limited to 90°. That is, the first connection ports 41 and the second connection ports 42 may be installed in parallel with each other, or may be separated by various angles.

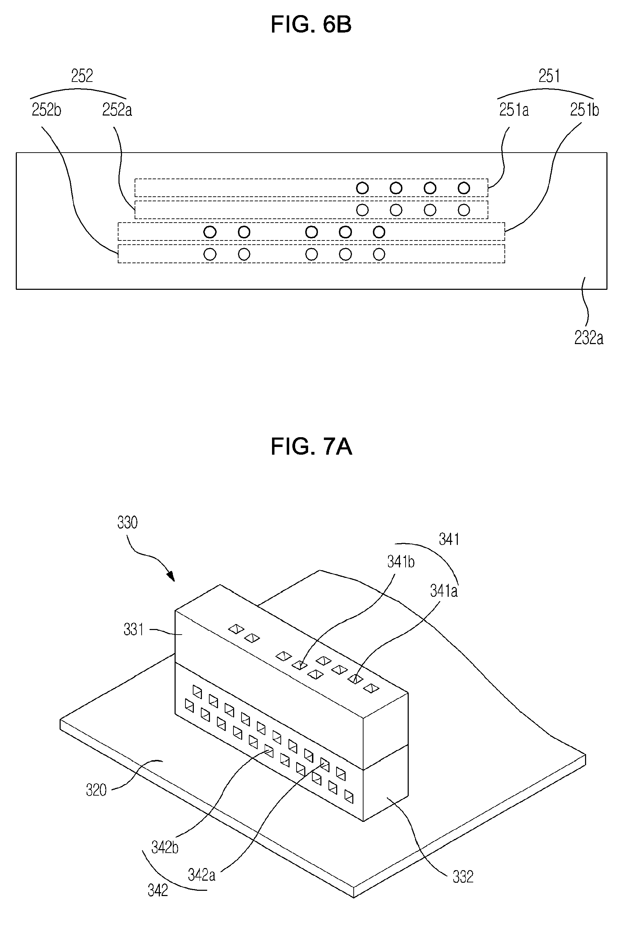

FIG. 6A is a perspective view illustrating a connector module 230 in accordance with another exemplary embodiment, and FIG. 6B is a bottom view of the connector module 230 of FIG. 6A. Hereinafter, parts of the connector module 230 as shown in FIGS. 6A and 6B, which are substantially different from those of the connector module 30 as shown in FIGS. 1 to 5, will be described in detail.

As shown in FIGS. 1 to 6B, first connection ports 241 are provided on a first housing 231. The first connection ports 241 are connected with a cable (not shown) of an external device. The first connection ports 241 represent component connection ports. In the exemplary embodiment of FIGS. 6A and 6B, nine component connection ports are provided, but a number of the component connection ports is not limited.

The first connection ports 241 are arranged in plural lines. For example, the first connection ports 241 includes a first line 241a including a number of connection ports 241, for example, four connection ports, and a second line 241 b including a number of connection ports 241, for example five connection ports.

First connection pins 251 are respectively connected to the first connection ports 241, and are then connected to a printed circuit board 220. Here, 9 first connection pins 251 are also provided.

The first connection pins 251 are arranged in plural lines. For example, the first connection pins 251 includes a first line 251a including a number of connection pins 251, for example four connection pins, and a second line 251b including a number of connection pins 251, for example five connection pins.

Second connection ports 242 are provided on a second housing 232. The second connection ports 242 are connected with a cable (not shown) of an external device. The second connection ports 242 represent component connection ports. In the exemplary embodiment, nine component connection ports are provided, but the number of component connection ports is not limited.

The second connection ports 242 are arranged in plural lines. For example, the second connection ports 242 includes a first line 242a including a number of connection ports 242, for example four connection ports, and a second line 242b including a number of connection ports 242, for example five connection ports.

Second connection pins 252 are respectively connected to the second connection ports 242, and are then connected to the printed circuit board 220. In the exemplary embodiment, nine second connection pins 252 are also provided, but the number is not limited.

The second connection pins 252 are arranged in plural lines. For example, the second connection pins 252 includes a first line 252a including a number of connection pins 252, for example, four connection pins, and a second line 252b including a number of connection pins 252, for example, five connection pins.

Particularly, as shown in FIG. 6B, both the first connection pins 251 and the second connection pins 252 are provided on a lower surface 232a of the second housing 232, the lower surface 232a facing the printed circuit board 220. The first connection pins 251 and the second connection pins 252 protrude from the lower surface 232a of the second housing 232.

The first connection pins 251 and the second connection pins 252 are arranged such that the first connection pins 251 at least partially intersect the second connection pins 252 when viewed from a direction that is parallel to the direction along which the plural lines are arranged, e.g., from a horizontal direction in FIG. 6B. That is, the plural lines 251a and 251 b of the first connection pins 251 and the plural lines 252a and 252b of the second connection pins 252 alternate with each other. For example, the first line 251a of the first connection pins 251, the first line 252a of the second connection pins 252, the second line 251b of the first connection pins 251, and the second line 252b of the second connection pins 252 are sequentially arranged in this order. The alternate arrangement of the first connection pins 251 and the second connection pins 252 reduces an area occupied by the connector module 230 on the printed circuit board 220.

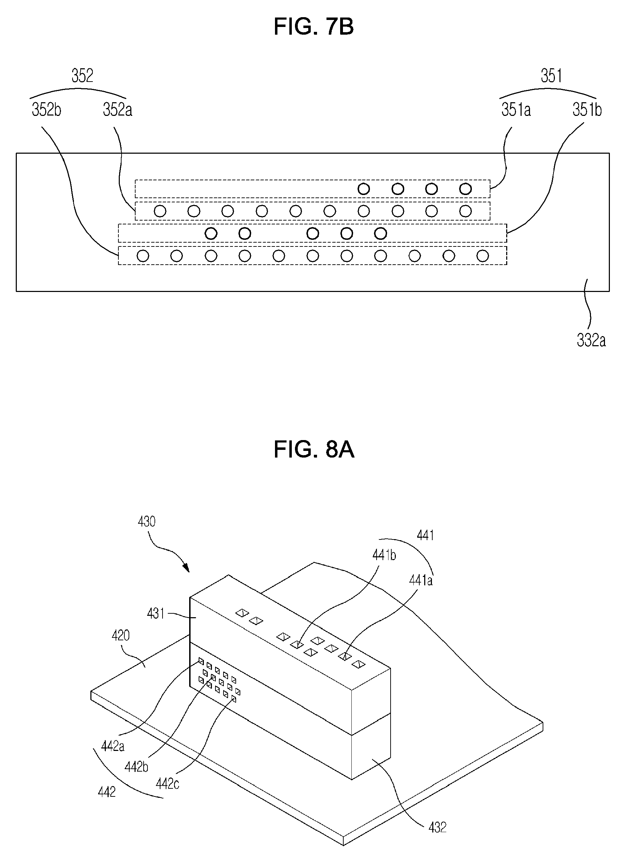

FIG. 7A is a perspective view illustrating a connector module 330 in accordance with another exemplary embodiment, and FIG. 7B is a bottom view of the connector module 330 of FIG. 7A. Hereinafter, parts of the connector module 330 as shown in FIGS. 7A and 7B, which are substantially different from those of the connector modules 30 and 230 as shown in FIGS. 1 to 6B, will be described in detail.

As shown in FIGS. 1 to 7B, first connection ports 341 are provided on a first housing 331. The first connection ports 341 are connected with a cable (not shown) of an external device. The first connection ports 341 represent component connection ports. In the exemplary embodiment, nine component connection ports are provided.

The first connection ports 341 are arranged in plural lines. For example, as shown in FIG. 7A, the first connection ports 341 include a first line 341a including a number of connection ports 341, such as four connection ports, and a second line 341b including a number of connection ports 341, such as five connection ports.

First connection pins 351 are respectively connected to the first connection ports 341, and are then connected to a printed circuit board 320. In the exemplary embodiment of FIGS. 7A and 7B, nine first connection pins 351 are provided, however this number is not limited.

The first connection pins 351 are arranged in plural lines. For example, the first connection pins 351 includes a first line 351a including a number of connection pins 351, such as four connection pins, and a second line 351b including a number of connection pins 351, such as five connection pins.

Second connection ports 342 are provided on a second housing 332. The second connection ports 342 are connected with a cable (not shown) of an external device. The second connection ports 342 represent SCART connection ports. In the exemplary embodiment, twenty-one SCART connection ports are provided, however the number of connection ports is not limited to twenty-one.

The second connection ports 342 are arranged in plural lines. For example, the second connection ports 342 includes a first line 342a including a number of connection ports 342, such as ten connection ports, and a second line 342b including a number of connection ports 342, such as eleven ports.

Second connection pins 352 are respectively connected to the second connection ports 342, and are then connected to the printed circuit board 320. In the exemplary embodiment, twenty-one second connection pins 352 are also provided, however this number is not limited. The second connection pins 352 are arranged in plural lines. For example, the second connection pins 352 includes a first line 352a including a number of connection pins 352, such as ten connection pins, and a second line 352b including a number of connection pins 352, such as eleven connection pins.

Particularly, as shown in FIG. 7B, both the first connection pins 351 and the second connection pins 352 are provided on a lower surface 332a of the second housing 332, the lower surface 332a facing the printed circuit board 320. The first connection pins 351 and the second connection pins 352 protrude from the lower surface 332a of the second housing 332.

The first connection pins 351 and the second connection pins 352 are arranged such that the first connection pins 351 at least partially intersect the second connection pins 352 when viewed from a direction parallel to the direction along which the plural lines are arranged, e.g., from a horizontal direction in FIG. 7B. That is, the plural lines 351a and 351b b of the first connection pins 351 and the plural lines 352a and 352b of the second connection pins 352 alternate with each other. For example, the first line 351 a of the first connection pins 351, the first line 352a of the second connection pins 352, the second line 351 b of the first connection pins 351, and the second line 352b of the second connection pins 352 are sequentially arranged in this order. The alternate arrangement of the first connection pins 351 and the second connection pins 352 reduces an area occupied by the connector module 330 on the printed circuit board 320.

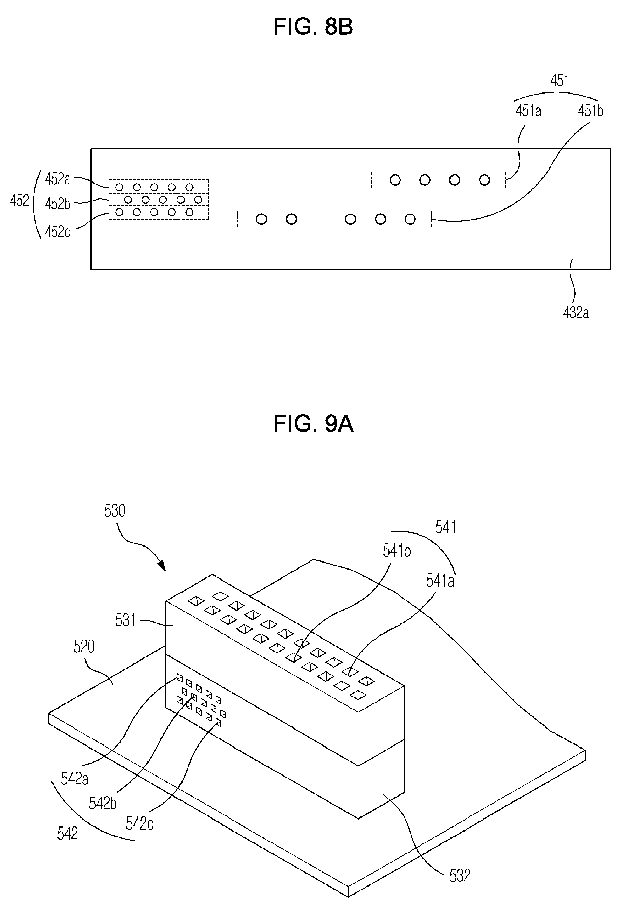

FIG. 8A is a perspective view illustrating a connector module 430 in accordance with another exemplary embodiment, and FIG. 8B is a bottom view of the connector module 430 of FIG. 8A. Hereinafter, parts of the connector module 430 as shown in FIGS. 8A and 8B, which are substantially different from those of the connector modules 30, 230, and 330 as shown in FIGS. 1 to 7B, will be described in detail.

As shown in FIGS. 1 to 8B, first connection ports 441 are provided on a first housing 431. The first connection ports 441 are connected with a cable (not shown) of an external device. The first connection ports 441 represent component connection ports. In the exemplary embodiment, nine component connection ports are provided, but the number of component connection ports is not limited.

The first connection ports 441 are arranged in plural lines. For example, the first connection ports 441 includes a first line 441a including a number of connection ports 441, such as four connection ports, and a second line 441b including a number of connection ports 441, such as five connection ports.

First connection pins 451 are respectively connected to the first connection ports 441, and are then connected to a printed circuit board 420. In the exemplary embodiment, nine first connection pins 451 are also provided, but the number of connection pins is not limited.

The first connection pins 451 are arranged in plural lines. For example, the first connection pins 451 includes a first line 451a including a number of connection pins 451, such as four connection pins, and a second line 451b including a number of connection pins 451, such as five connection pins.

Second connection ports 442 are provided on a second housing 432. The second connection ports 442 are connected with a cable (not shown) of an external device. The second connection ports 442 represent, for example, DSUB connection ports. In the exemplary embodiment, fifteen DSUB connection ports are provided, however the type and number of the connection ports are not limited.

The second connection ports 442 are arranged in plural lines. For example, the second connection ports 442 includes a first line 442a including a number of connection ports 442, such as five connection ports, a second line 442b including a number of connection ports 442, such as five connection ports, and a third line 442c including a number of connection ports 442, such as five connection ports.

Second connection pins 452 are respectively connected to the second connection ports 442, and are then connected to the printed circuit board 420. In the exemplary embodiment, fifteen second connection pins 452 are also provided, however the number of connection pins is not limited.

The second connection pins 452 are arranged in plural lines. For example, the second connection pins 452 includes a first line 452a including a number of connection pins 452, such as five connection pins, a second line 452b including a number of connection pins 452, such as five connection pins, and a third line 452c including a number of connection pins 452, such as five connection pins.

Particularly, as shown in FIG. 8B, both the first connection pins 451 and the second connection pins 452 are provided on a lower surface 432a of the second housing 432, the lower surface 432a facing the printed circuit board 420. The first connection pins 451 and the second connection pins 452 protrude from the lower surface 432a of the second housing 432.

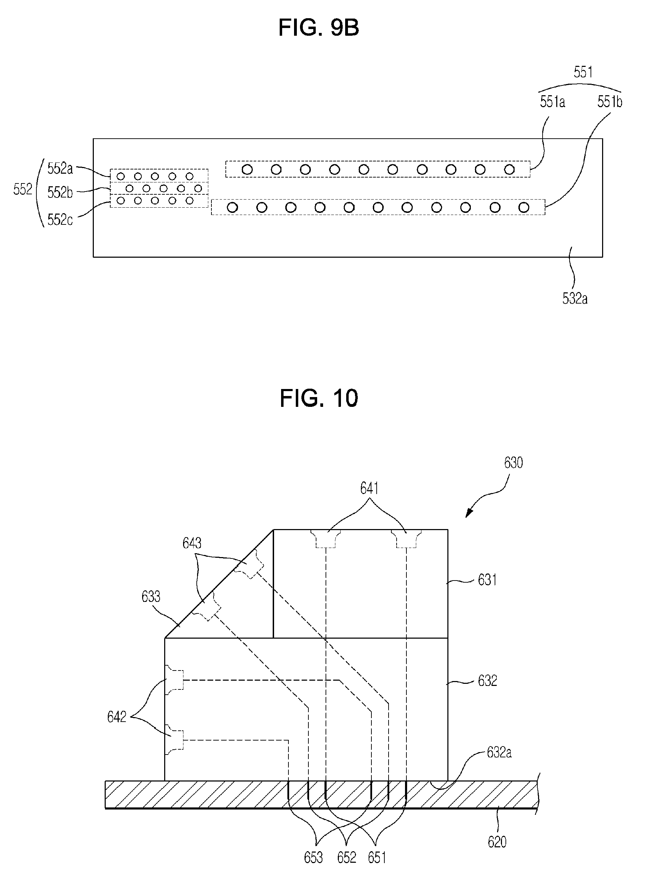

The first connection pins 451 and the second connection pins 452 do not intersect when viewed from a horizontal direction of FIG. 8B, but are provided along a same line extending in a lengthwise direction parallel to the direction along which the plural lines are arranged, e.g., the horizontal direction of FIG. 8B. That is, the first connection pins 451 and the second connection pins 452 are formed on the lower surface 432a of the second housing 432 in the lengthwise direction. For example, the first connection pins 451 are formed at the right portion of the lower surface 432a of the second housing 432, and the second connection pins 452 are formed at the left portion of the lower surface 432 of the second housing 432. The arrangement of the first connection pins 451 and the second connection pins 452 on the same line reduces an area occupied by the connector module 430 on the printed circuit board 420. FIG. 9A is a perspective view illustrating a connector module 530 in accordance with another exemplary embodiment, and FIG. 9B is a bottom view of the connector module 530 of FIG. 9A. Hereinafter, parts of the connector module 530 as shown in FIGS. 9A and 9B, which are substantially different from those of the connector modules 30, 230, 330, and 430 as shown in FIGS. 1 to 8B, will be described in detail.

As shown in FIGS. 1 to 9B, first connection ports 541 are provided on a first housing 531. The first connection ports 541 are connected with a cable (not shown) of an external device. The first connection ports 541 represent SCART connection ports, for example. In the exemplary embodiment, twenty-one SCART connection ports are provided, however the type and number of connection ports is not limited.

The first connection ports 541 are arranged in plural lines. For example, the first connection ports 541 includes a first line 541a including a number of connection ports 541, such as ten connection ports, and a second line 541 b including a number of connection ports 541, such as eleven connection ports.

First connection pins 551 are respectively connected to the first connection ports 541, and are then connected to a printed circuit board 520. In the exemplary embodiment, twenty-one first connection pins 551 are also provided, but the number of connection pins is not limited.

The first connection pins 551 are arranged in plural lines. For example, the first connection pins 551 includes a first line 551a including a number of connection pins 551, such as ten connection pins, and a second line 551b including a number of connection pins 551, such as eleven connection pins.

Second connection ports 542 are provided on a second housing 532. The second connection ports 542 are connected with a cable (not shown) of an external device. The second connection ports 542 represent DSUB connection ports, for example. In the exemplary embodiment, fifteen DSUB connection ports are provided, however the type and number of connection ports is not limited.

The second connection ports 542 are arranged in plural lines. For example, the second connection ports 542 includes a first line 542a including a number of connection ports 542, such as five connection ports, a second line 542b including a number of connection ports 542, such as five connection ports, and a third line 542c including a number of connection ports 542, such as five connection ports.

Second connection pins 552 are respectively connected to the second connection ports 542, and are then connected to the printed circuit board 520. In the exemplary embodiment, fifteen second connection pins 552 are also provided, but the number of connection ports is not limited.

The second connection pins 552 are arranged in plural lines. For example, the second connection pins 552 includes a first line 552a including a number of connection pins 552, such as five connection pins, a second line 552b including a number of connection pins 552, such as five connection pins, and a third line 552c including a number of connection pins 552, such as five connection pins.

Particularly, as shown in FIG. 9B, both the first connection pins 551 and the second connection pins 552 are provided on a lower surface 532a of the second housing 532, the lower surface 532a facing the printed circuit board 520. The first connection pins 551 and the second connection pins 552 protrude from the lower surface 532a of the second housing 552.

The first connection pins 551 and the second connection pins 552 do not intersect when viewed from a horizontal direction in FIG. 9B, but are provided along a same line which extends in a lengthwise direction parallel to a direction along which the plural lines are arranged. That is, the first connection pins 551 and the second connection pins 552 are formed on the lower surface 432a of the second housing 532 in the lengthwise direction. For example, the first connection pins 551 are formed at the right portion of the lower surface 532a of the second housing 532, and the second connection pins 552 are formed at the left portion of the lower surface 532 of the second housing 532. The arrangement of the first connection pins 551 and the second connection pins 552 on the same line reduces an area occupied by the connector module 530 on the printed circuit board 520.

FIG. 10 is a cross-sectional view illustrating a connector module 630 in accordance with another exemplary embodiment.

Hereinafter, parts of the connector module 630 as shown in FIG. 10, which are substantially different from those of the connector modules 30, 230, 330, 430, and 530 as shown in FIGS. 1 to 9B, will be described in detail.

As shown in FIG. 10, the connector module 630 includes a first housing 631, first connection ports 641 provided on the first housing 631, a second housing 632, second connection ports 642 provided on the second housing 632, a third housing 633, and third connection ports 643 provided on the third housing 633.

The first connection ports 641 provided on the first housing 631, the second connection ports 642 provided on the second housing 632, and the third connection ports 643 provided on the third housing 633 are arranged at designated angles relative to one another. As described above, the first, second, and third connection ports 641, 642, and 643 are provided on one connector module 630, thereby reducing an area occupied by the connector module 630 on a printed circuit board 620. As shown in FIG. 10, the first housing 631 and third housing 633 are disposed on the second housing 632 on a surface of the second housing 632 opposite to a lower surface 632a. An area occupied by the first housing 631 and the third housing 633 is substantially equal to the area occupied by the second housing 632.

First connection pins 651 are respectively connected to the first connection ports 641, and are then connected to a printed circuit board 620. The first connection pins 651 are arranged in plural lines.

Second connection pins 652 are respectively connected to the second connection ports 642, and are then connected to a printed circuit board 620. The second connection pins 652 are arranged in plural lines.

Third connection pins 653 are respectively connected to the third connection ports 643, and are then connected to a printed circuit board 620. The third connection pins 653 are arranged in plural lines.

The plural lines of the first connection pins 651 are arranged with at least one of the second connection pins 652 and the third connection pins 653 disposed therebetween. Similarly, the plural lines of the second connection pins 652 are arranged with at least one of the first connection pins 651 and the third connection pins 653 disposed therebetween, and the plural lines of the third connection pins 653 are arranged with at least one of the first connection pins 651 and the second connection pins 652 disposed therebetween.

Further, installation of four or more kinds of connection ports on a single connector module may be possible and a detailed description thereof will be omitted because it is considered to be unnecessary.

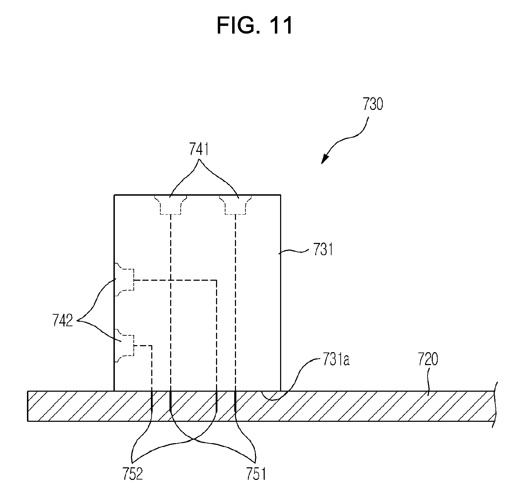

FIG. 11 is a cross-sectional view illustrating a connector module 730 in accordance with a further exemplary embodiment.

Hereinafter, parts of the connector module 730 as shown in FIG. 11, which are substantially different from those of the connector modules 30, 230, 330, 430, 530, and 630 as shown in FIGS. 1 to 10, will be described in detail.

As shown in FIG. 11, the connector module 730 includes a housing 731, first connection ports 741 provided at one surface of the housing 731, and second connection ports 742 provided at another surface of the housing 731 different than the first surface. That is, a single integral housing is provided instead of a plurality of separate housings, such as first, second, and third housings.

The first connection ports 741 are provided at the one surface of the housing 731 and are exposed in the upward direction, and the second connection ports 742 are provided at the other surface of the housing 731 and are exposed in the forward direction (leftward direction in FIG. 11). That is, the first connection ports 741 and the second connection ports 742 are disposed on surfaces that extend at different angles relative to one another, thereby preventing cables connected to the first connection ports 741 and the second connection ports 742 from interfering with each other.

Further, both first connection pins 751 of the first connection ports 741 and second connection pins 752 of the second connection ports 742 are provided on a lower surface 731a of the housing 731, the lower surface 731a facing a printed circuit board 720. An arrangement of the first connection pins 751 of the first connection ports 741 and the second connection pins 752 of the second connection ports 742 is similar to the above-described arrangement. Thereby, an area occupied by the connector module 730 on the printed circuit board 720 is reduced.

As is apparent from the above description, a connector module in accordance with the exemplary embodiments achieves efficient space use.

Further, the connector module reduces an area occupied thereby on a printed circuit board, thus reducing material costs of the printed circuit board.

Moreover, the connector module varies connection angles of respective cables, thereby preventing the respective cables from interfering with each other.

Although a few exemplary embodiments have been shown and described, it would be appreciated by those skilled in the art that changes may be made in these exemplary embodiments without departing from the principles of the inventive concept, the scope of which is defined in the claims and their equivalents.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features. The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A connector module comprising:
a first housing;
a plurality of first connection ports provided at a first surface of the first housing;
a plurality of first connection pins connected to the plurality of first connection ports and to a circuit board;
a second housing;
a plurality of second connection ports provided at a first surface of the second housing; and
a plurality of second connection pins connected to the plurality of second connection ports and to the circuit board,
wherein the first connection pins and the second connection pins extend through a second surface of one of the first housing and the second housing, the second surface facing the circuit board.

2. The connector module according to claim 1, wherein:
the first housing and the second housing are vertically disposed on top of one another; and
the plurality of first connection pins and the plurality of second connection pins protrude from the second surface of the one of the first housing and the second housing.

3. The connector module according to claim 2, wherein the plurality of first connection ports provided at the first surface of the first housing and the plurality of second connection ports provided at the first surface of the second housing are arranged at a designated angle relative to one another.

4. The connector module according to claim 1, wherein the plurality of first connection pins at least partially overlap the plurality of second connection pins in a direction perpendicular to the one surface of the first housing and the one surface of the second housing.

5. The connector module according to claim 4, wherein:
the plurality of first connection pins are arranged in a plurality of lines, and the plurality of second connection pins are arranged in a plurality of lines; and
the plurality of lines of the first connection pins and the plurality of lines of the second connection pins are alternately arranged.

6. The connector module according to claim 5, wherein:
the plurality of first connection ports and the plurality of second connection ports are component connection ports; and
the plurality of first connection pins and the plurality of second connection pins are component connection pins.

7. The connector module according to claim 5, wherein:
the plurality of first connection ports and the plurality of second connection ports are Syndicat francais des Constructeurs d'Appareils Radio et Television (SCART) connection ports; and
the plurality of first connection pins and the plurality of second connection pins are SCART connection pins.

8. The connector module according to claim 5, wherein:
one of the plurality of first connection ports and the plurality of second connection ports comprises a plurality of component connection ports, and the other of the plurality of first connection ports and the plurality of second connection ports comprises a plurality of Syndicat francais des Constructeurs d'Appareils Radio et Television (SCART) connection ports; and
one of the plurality of first connection pins and the plurality of second connection pins comprises a plurality of component connection pins, and the other of the plurality of first connection pins and the plurality of second connection pins comprises a plurality of SCART connection pins.

9. The connector module according to claim 2, wherein the plurality of first connection pins are provided at one portion of the other surface of the one of the first housing and the second housing, and the plurality of second connection pins are provided at another portion of the other surface of the one of the first housing and the second housing.

10. The connector module according to claim 9, wherein:
one of the plurality of first connection ports and the plurality of second connection ports comprises a plurality of component connection ports, and another of the plurality of first connection ports and the plurality of second connection ports comprises a plurality of D-subminiature (DSUB) connection ports; and
one of the plurality of first connection pins and the plurality of second connection pins comprises a plurality of component connection pins, and another of the plurality of first connection pins and the plurality of second connection pins comprises a plurality of DSUB connection pins.

11. The connector module according to claim 9, wherein:
one of the plurality of first connection ports and the plurality of second connection ports comprises a plurality of Syndicat francais des Constructeurs d'Appareils Radio et Television (SCART) connection ports, and another of the plurality of first connection ports and the plurality of second connection ports comprises a plurality of D-subminiature (DSUB) connection ports; and
one of the plurality of first connection pins and the plurality of second connection pins comprises a plurality of SCART connection pins, and another of the plurality of first connection pins and the plurality of second connection pins comprises a plurality of DSUB connection pins.

12. The connector module according to claim 1, further comprising:
a third housing;
a plurality of third connection ports provided at a first surface of the third housing; and
a plurality of third connection pins connected to the plurality of third connection ports and to the circuit board,
wherein all of the first connection pins, the second connection pins, and the third connection pins are provided on the second surface of the one of the first housing and the second housing.

13. The connector module according to claim 12, wherein the plurality of first connection ports of the first housing, the plurality of second connection ports of the second housing, and the plurality of third connection ports of the third housing are arranged at designated angles relative to one another.

14. An electronic device comprising:
a circuit board;
a housing;
a plurality of first connection ports provided at a first surface of the housing;
a plurality of first connection pins connected to the plurality of first connection ports and to the printed circuit board;
a plurality of second connection ports provided at a second surface of the housing; and
a plurality of second connection pins connected to the plurality of second connection ports and to the circuit board,
wherein the plurality of first connection pins and the plurality of second connection pins are both provided on a third surface of the housing, the third surface facing the printed circuit board.

15. The electronic device according to claim 14, wherein the plurality of first connection ports and the plurality of second connection ports are arranged at a designated angle relative to one another.
